# EUROPÄISCHE PATENTSCHRIFT

(11) **EP 1 564 804 B1**
(45) Veröffentlichungstag und Bekanntmachung des Hinweises auf die Patenterteilung: **21.04.2010**
(21) Anmeldenummer: 05002752.3
(22) Anmeldetag: 10.02.2005
(51) Int. Cl.: H01L 21/68, H01L 21/00, H01L 21/20

(54) **Vorrichtung und Verfahren zum Verbinden von Wafern**
An appartus and a method for bonding wafers
Un appareil et un procédé pour joindre des wafers

(30) Priorität: 13.02.2004 DE 102004007060
(43) Veröffentlichungstag der Anmeldung: 17.08.2005
(73) Patentinhaber: Thallner, Erich, Dipl.-Ing., 4782 St. Florian (AT)
(72) Erfinder: Thallner, Erich, Dipl.-Ing., 4782 St. Florian (AT)
(74) Vertreter: Schweiger, Johannes

(56) Entgegenhaltungen:
- EP-A- 0 886 306
- EP-A- 1 278 245
- WO-A-2004/010481
- US-A1- 2002 134 503
- US-A1- 2003 045 044
- US-A1- 2003 122 141

## Beschreibung

Die Erfindung betrifft eine Vorrichtung und ein Verfahren zum Verbinden von Wafern.

Verschiedene Schlüsseltechnologien wurden zur Verbindung von Wafern bzw. Waferoberflächen entwickelt und sind im Stand der Technik hinreichend bekannt. Dazu zählen:
- aligned wafer bonding / Ausrichtungs-Wafer-Bonden
- front-to-backside photolithography / Vorder- und Rückseiten Photolithographie
- customized resist coating

Die vorliegende Erfindung betrifft in erster Linie das Ausrichtungs-Wafer-Bonden, bei dem wiederum verschiedene Verfahren zum Einsatz kommen. Diese sind in der Literatur ebenfalls umfassend beschrieben. Hierunter fallen unter anderem:
- anodisches/elektrostatisches Bonden von Silikon auf Glas
- Niedrigtemperatur-Glass-frit-Bonden von Silikon auf Silikon
- Direkt-Wafer-Bonden (DWB) oder Fusionsbonden

Weitere Verfahren sind das eutektische Bonden, Epoxy-Bonden, Thermokompressions-Bonden und Glas-auf-Glas-Bonden.

Dabei bestehen die im Stand der Technik beschriebenen Verfahren zum Ausrichtungs-Wafer-Bonden immer aus den folgenden zwei getrennten und unterschiedlichen Schritten. Zunächst werden die beiden übereinander angeordneten Wafer mit Hilfe einer

Ausrichtungseinrichtung mit einer Genauigkeit von ± 1 µm ausgerichtet, wobei sich die Oberflächen der beiden Wafer, die miteinander verbunden werden sollen, gegenüberliegen. Bei diesem ersten Schritt ist es notwendig, einen Separationsabstand zwischen den beiden zu verbindenden Oberflächen aufrechtzuerhalten. Dieser wird im Stand der Technik meist durch Abstandhalter verwirklicht, die am Umfang der Wafer verteilt sind, wobei eine möglichst kleine Oberfläche von diesen bedeckt wird. Um jedoch einen stabilen Halt zu gewährleisten, sind zumindest drei solche Abstandhalter notwendig.

Anschließend werden die beiden Wafer in einer Vakuumkammer unter Vakuum gesetzt, wonach mittels einer Computersteuerung die beiden vorher ausgerichteten Wafer in Kontakt gebracht und durch eines der oben beschriebenen Verfahren verbunden bzw. gebondet werden. Zum Kontaktieren werden die am Umfang angeordneten Abstandhalter gleichmäßig herausgezogen, damit die vorher ausgerichteten Spacer nicht mehr verrutschen.

Die bisher bekannten Verfahren zum Ausrichtungs-Wafer-Bonden weisen folglich zwei wesentliche Nachteile auf. Zum einen entstehen durch die Abstandhalter Lücken in der Kontaktfläche, auf der anderen Seite besteht beim Kontaktieren durch Herausziehen der Abstandhalter die Gefahr, dass die vorher genau positionierten Wafer relativ zueinander verrutschen.

Solche Vorrichtungen und Verfahren sind in der EP-A-1 278 245, WO-A-2004670487 und der EP-A-0 886 306 gezeigt.

Es ist die Aufgabe der vorliegenden Erfindung, ein Verfahren und eine Vorrichtung vorzusehen, mit welchen scheibenförmige Teile, insbesondere Halbleiterscheiben exakt ausgerichtet und bestmöglich miteinander verbunden werden können.

Grundidee der Erfindung ist es, die Teile zunächst temporär miteinander zu verbinden. Dabei werden die Teile justiert. Anschließend erfolgt die endgültige Verbindung zu einem Verbundkörper.

Soweit im Zusammenhang mit der Erfindung von Wafer gesprochen wird, steht dies stellvertretend für jede Art eines zu justierenden flächigen Bauteils.

Die genannte Aufgabe wird durch eine Vorrichtung nach Anspruch 1 und ein Verfahren nach Anspruch 10 zum Verbinden von Wafern an korrespondierenden Oberflächen der Wafer gelöst.

Die erste Einrichtung kann aus einer tischartigen Auflage bestehen, beispielsweise nach Art eines "Chuck". Der Tisch kann statisch oder drehbar ausgebildet sein. Der erste Wafer kann unmittelbar oder mittelbar auf der Auflage aufliegen.

Auf den zweiten Wafer und/oder den ersten Wafer wird eine Schicht von Verbindungsmittel aufgebracht, bevor der zweite Wafer mit dem ersten Wafer in Kontakt gebracht wird. Die Schicht kann sowohl als vollflächige Schicht oder als gemusterte Schicht auf den jeweiligen Wafer aufgebracht werden.

Als Verbindungsmittel kommen Kleber in Betracht, die je nach Substrat der Wafer ausgewählt werden und ausreichend viskos sein sollten, um eine Verschiebung der Wafer nach der Kontaktierung der korrespondierenden Oberflächen der Wafer zu ermöglichen. Gute Ergebnisse werden zum Beispiel mit UV-härtbaren Epoxy-Harz-Klebern erzielt.

Auf diese Art und Weise wird eine Vorrichtung geschaffen, die ohne Kontaktstifte auskommt, woraus folgt, dass keine Lücken auf den Kontaktflächen der korrespondierenden Oberflächen der Wafer entstehen. Weiterhin hat die erfindungsgemäße Vorrichtung den Vorteil, dass eine genaue Ausrichtung erst erfolgt, nachdem die korrespondierenden Oberflächen der Wafer in Kontakt gebracht wurden. Dadurch kann ein Verrutschen der Wafer nach der Ausrichtung durch die Ausrichtungsmittel ausgeschlossen werden. Es wird eine wesentlich genauere Ausrichtung der beiden Wafer erreicht, wodurch die Qualität der mit der erfindungsgemäßen Vorrichtung hergestellten Wafer deutlich zunimmt.

Anders ausgedrückt: Entlang der korrespondierenden Oberflächen der zu verbindenden Teile (hier: Wafer) erfolgt eine vollflächige Verklebung oder eine musterartige Verklebung, wobei das Muster nicht durch Abdrücke von Stiften gestört wird.

Die Ausrichtungsmittel können eine Erfassungseinrichtung zur Erfassung der relativen Position der beiden auszurichtenden Wafer zueinander umfassen, wobei die Erfassungseinrichtung mittels einer ersten Wirkverbindung zwischen der Steuerungseinheit und den Erfassungseinrichtung Signale über die relative Position der Wafer zueinander an die Steuerungseinheit übermittelt.

Die Erfassungseinrichtung sorgt für die exakte Ausrichtung der Wafer, indem sie die relative Position der Wafer erfasst, an die Steuerungseinheit weitergibt, welche dann eine Ausrichtung der Wafer zueinander bewirkt.

Die Erfassungseinrichtung kann kontaktlos, insbesondere optisch ausgestaltet sein. Beispielsweise wird durch die Erfassungseinrichtung mit sichtbarem und/oder infrarotem Licht die relative Position der Wafer zueinander ermittelt. Dazu können an den Wafern integrierte Justiermarken angebracht sein. In einfachster Ausgestaltung können hierfür Punkte, Symbole oder Flächen auf den beiden Wafern in Übereinstimmung gebracht werden.

Eine noch exaktere Ausrichtung wird dadurch erreicht, dass die Justiermarken Skalenstriche sind, die auf den Wafern aufgebracht sind. Die Skalenstriche weisen eine vordefinierte Teilung auf, aus der die Erfassungseinrichtung die relative Position der Wafer zueinander ermitteln kann. Die Skalen können jedoch auch in jeder anderen Form aufgebracht sein, beispielsweise in Form von ineinandergeschachtelten Kreisen, nach Art einer Zielscheibe. Es sind auch farbige Bildpunkte mit einer bestimmten Anordnung als Justiermarken denkbar.

Zum Ausrichten der Wafer dienen mechanische Mittel, die den jeweiligen Wafer drehen und/oder verschieben, sobald entsprechende Signale von der Steuerungseinheit vorliegen, wie in Anspruch 4 präzisiert.

Die zu verbindenden Teile können zum Beispiel aus Glas oder Silizium bestehen.

Bei dem erfindungsgemäßen Verfahren können die Wafer optisch ausgerichtet werden. Dazu dient eine entsprechende optische Messeinheit. Die Mittel zum Ausrichten (Justieren) können zumindest teilweise in die zu justierenden Teile integriert sein. Mindestens eine Justiermarke an jedem Justierteil ist notwendig. Beim Verfahrensschritt B können die Wafer bereits grob anhand der Waferkanten ausgerichtet werden. Die Ausrichtung durch die Verschiebemittel entlang den in Kontakt stehenden korrespondierenden Oberflächen der Wafer kann durch Rotation und/oder Verschiebung in X-Y-Richtung erfolgen.

Bezüglich weiterer Ausführungsformen zu den einzelnen Verfahrensschritten wird auf die vorstehenden Erläuterungen im Zusammenhang mit der Vorrichtung sowie die nachstehende Figurenbeschreibung Bezug genommen.

Weitere Merkmale der Erfindung ergeben sich aus den Merkmalen der Unteransprüche sowie den sonstigen Anmeldungsunterlagen.

Die Erfindung wird nachstehend anhand eines Ausführungsbeispieles näher erläutert. Die darin beschriebenen Merkmale können sowohl einzeln als auch in beliebigen Kombinationen für die Verwirklichung der Erfindung von Bedeutung sein. Dies gilt auch für die Merkmale, die vorstehend zur Beschreibung der Vorrichtung und des Verfahrens genannt wurden. Die Figuren der Zeichnung zeigen im Einzelnen:
Fig. 1 eine Aufsicht auf die erfindungsgemäße Vorrichtung vor Beginn des erfindungsgemäßen Verfahrens in schematisierter Darstellung
Fig. 2 eine schematische Schnittansicht gemäß Schnittlinie A-A aus Figur 1, die den Verfahrensschritt der Ausrichtung der Wafer relativ zueinander nach der Kontaktierung zeigt.

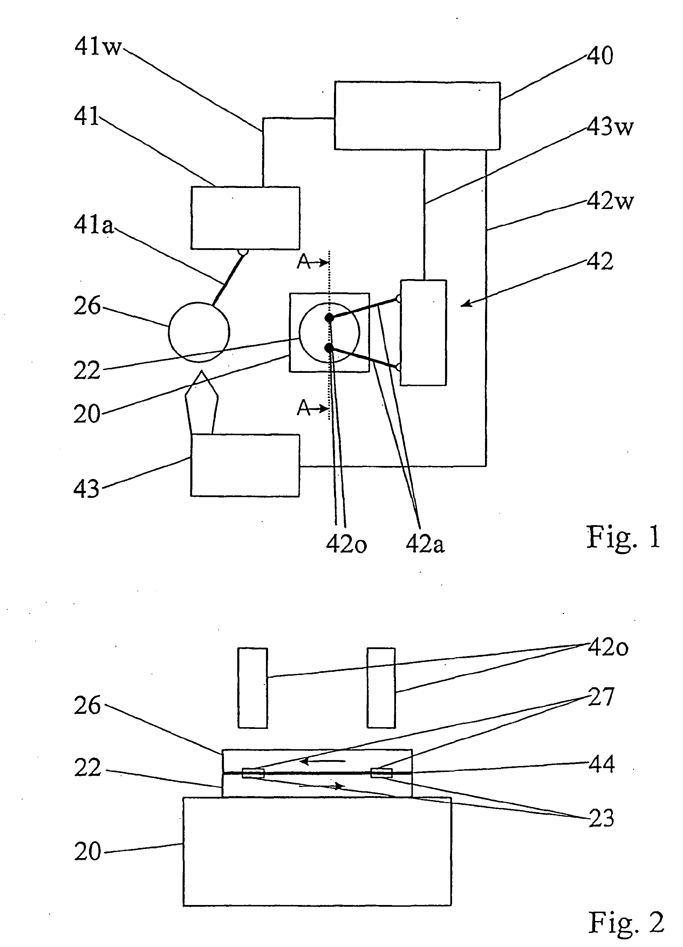

In Figur 1 ist ― stark schematisiert - eine Steuerungseinheit 40 gezeigt, die eine Durchführung des Verfahrens gemäß den in der obigen Beschreibung beschriebenen Verfahrensschritten in einer beispielhaften Ausgestaltung der vorliegenden Erfindung bewirkt.

Die Steuerungseinheit 40 ist hier durch eine erste, zweite und dritte Wirkverbindung 41w, 42w und 43w jeweils mit einer Einrichtung 41 zur Aufnahme und Ausrichtung des zweiten Wafers 26, mit einer Erfassungseinrichtung 42 zur Erfassung der Position der Wafer relativ zueinander und einer Einheit 43 zum Aufbringen eines Verbindungsmittels 44 verbunden.

Die zweite Einrichtung 41 zur Aufnahme und Ausrichtung des zweiten Wafers 26 ist mit dem Wafer 26 über einen schwenkbaren Arm 41a verbunden, um den zweiten Wafer 26 von der Einheit 43 zur einer ersten Einrichtung 20 zur Aufnahme des ersten Wafers 22 zu bewegen. Die räumliche Anordnung der Einrichtungen zueinander ist nur beispielhaft.

Nicht dargestellte Greifer am Ende des Armes 41a halten den zweiten Wafer 26 und sind dem Fachmann bekannt. Vorteilhaft ist die Verwendung von kontaktlosen Bernoulli-Greifern.

Mit der Einheit 43 wird ein Klebstoff durch bekannte Verfahren wie Aufsprühen, Aufschleudern, Aufdrucken oder andere Verfahren auf den zweiten Wafer 26 und/oder den ersten Wafer 22 aufgebracht. Die Kleberschicht kann ganzflächig oder strukturiert, beispielsweise durch Siebdruck, aufgebracht werden.

Sobald das Verbindungsmittel (der Klebstoff) auf einen oder beide Wafer aufgebracht ist, werden die korrespondierenden Oberflächen der Wafer in Kontakt gebracht, indem der zweite Wafer 26 mit dem schwenkbaren Arm - gesteuert von der Steuerungseinheit 40 ― über den ersten Wafer 22 geschwenkt und auf diesen abgesenkt wird.

Sobald die beiden Wafer 22 und 26 in Kontakt stehen, erfasst die Erfassungseinrichtung 42 mittels zumindest zweier hochauflösender Objektive 42o, die über Arme 42a mit einem Gehäuse der Erfassungseinrichtung 42 verbunden sind, die Position der Wafer 22 und 26 relativ zueinander. Dazu sind in den beiden Wafern 22 und 26 je zwei Justiermarken 23 und 27 integriert. Die Justiermarken 23 und 27 können auf die Wafer 22 und 26 aufgebracht sein bzw. diesen zugeordnet sein. Die Erfassung kann auch mit einem Objektiv 42o erfolgen. Die Genauigkeit ist jedoch ― bedingt durch den geringeren möglichen Abstand von den Justiermarken 23 und 27 ― bei Verwendung eines Objektives pro Justiermarke 23, 27 wesentlich höher. Auch ist es möglich, lediglich ein Objektiv 42o und eine dazugehörige Justiermarke auf jedem Wafer 22 und 26 zur Erfassung zu verwenden, indem nur mit Hilfe der Ausgestaltung der Justiermarke ausgerichtet wird. Die Verwendung von mehr als zwei Justiermarken erhöht die Genauigkeit nur unwesentlich, weshalb aus Kostengründen darauf verzichtet werden kann.

Die Objektive 42o sind schwenkbar über Arme 42a am Gehäuse der Erfassungseinrichtung 42 angebracht, so dass die Objektive 42o beim Kontaktieren der beiden Wafer 22 und 26 aus dem Wirkungsbereich des Armes 41a und des Wafers 26 gebracht werden können.

Die Erfassungseinrichtung 42 sendet dann die Signale zur Bestimmung der relativen Position der beiden Wafer 22 und 26 zueinander an die Steuerungseinheit 40, die je nach Position der Wafer 22, 26 zueinander eine Verschiebung des zweiten Wafers 26 mit Hilfe der Einrichtung 42 bewirkt. Die Verschiebung der beiden in Kontakt stehenden Wafer 22 und 26 ist durch Auswahl eines geeigneten Klebers 44 möglich, der ausreichend viskos ist, um durch Einleitung einer Kraft parallel zur Waferoberfläche eine Verschiebung zu ermöglichen. Die Viskosität kann zusätzlich durch die Steuerung der Temperatur beeinflusst werden. Zur Ausrichtung der Wafer 22,26 können diese verschoben und/oder gedreht werden.

Die Justiermarken 23 und 27 sind als korrespondierende Skalenstriche auf die beiden Wafer ausgebildet, so dass bei einer Teilung der Skalenstriche von beispielsweise 500nm im Rahmen der optischen Auflösung der Objektive 42o eine exakte Justierung mit einer Abweichung von <=500nm erreicht wird.

Sobald die Justierung beendet ist, wird von der Steuereinheit die Aushärtung des Verbindungsmittels bewirkt, die beispielsweise mittels UV-Licht oder Erhöhung der Temperatur erreicht wird. Eine Einrichtung zum Aushärten des Verbindungsmittels ist hier nicht dargestellt.

Alternativ kann die Ausrichtung der beiden Wafer 22 und 26 auch oder zusätzlich durch Verschiebung und/oder Rotation der Einrichtung 20 zur Aufnahme des ersten Wafers 22 erfolgen.

Die Einrichtung 41 dient hier gleichzeitig als Verschiebemittel für den Ausrichtungsschritt gemäß der vorliegenden Erfindung. Gleichwohl ist der Einsatz einer zusätzlichen Einrichtung als Verschiebemittel denkbar, die nur für die exakte Positionierung der Wafer zueinander verantwortlich ist. Hierdurch kann die große Verschwenkung des zweiten Wafers 26 mit Hilfe einer wesentlich ungenaueren und deshalb auch billigeren Einrichtung erfolgen.

Die gesamte Vorrichtung kann auch in einer Vakuumkammer angeordnet sein, in der auch weitere übliche Verfahrensschritte wie ein Vorreinigungsschritt oder eine Spülung mit Inertgas integriert sein können.

Die genannten Verfahrensschritte werden von einer Steuerungseinheit 40 veranlasst und überwacht, die mit den einzelnen Vorrichtungsteilen steuerungstechnisch verbunden ist.

Das vorliegend beschriebene Verfahren beschleunigt die Verbindung der Wafer, indem der Verfahrensschritt, Abstandhalter zwischen die Wafer zu bringen und diese wieder gleichmäßig zu entfernen, wegfällt. Durch die geringere Entfernung der Justiermarken zueinander im Vergleich mit den Vorrichtungen aus dem Stand der Technik wird die Präzision der Ausrichtung weiter erhöht. Die mögliche vollflächige Verklebung ist ein weiterer Vorteil gegenüber dem Stand der Technik.

## Patentansprüche

1. Vorrichtung zum Verbinden von Wafern (22, 26) an korrespondierenden Oberflächen (22o, 26o) der Wafer (22, 26), mit folgenden Merkmalen:
a. einer Einheit (43) zum Aufbringen einer Schicht von Verbindungsmittel (44) auf zumindest eine der Oberflächen (22o, 26o) der Wafer (22, 26),
b. einer ersten Einrichtung (20) zur Aufnahme und Ausrichtung eines ersten Wafers (22),
c. einer zweiten Einrichtung (41) zur Aufnahme und Ausrichtung eines zweiten Wafers (26) gegenüber dem ersten Wafer (22) und zur Kontaktierung der korrespondierenden Oberflächen (22o, 26o) der Wafer (22, 26),
d. einer Steuerungseinheit (40),
**dadurch gekennzeichnet, dass**
die Vorrichtung Ausrichtungsmittel zur Ausrichtung der Wafer (22, 26) entlang den durch eine vollflächige oder musterartige Verklebung in Kontakt stehenden korrespondierenden Oberflächen (22o, 26o) der Wafer (22, 26) umfasst und die Ausrichtungsmittel eine Erfassungseinrichtung (42) zur Erfassung der relativen Position der beiden in Kontakt stehenden auszurichtenden Wafer (22, 26) zueinander umfasst.

2. Vorrichtung nach Anspruch 1, wobei die Erfassungseinrichtung (42) mittels einer ersten Wirkverbindung (42w) zwischen der Steuerungseinheit (40) und der Erfassungseinrichtung (42) Signale über die relative Position der Wafer (22, 26) zueinander an die Steuerungseinheit (40) übermittelt.

3. Vorrichtung nach Anspruch 1, deren Erfassungseinrichtung (42) kontaktlos, insbesondere optisch, ausgebildet ist.

4. Vorrichtung nach Anspruch 1, deren Ausrichtungsmittel Verschiebemittel (41) umfassen, die von der Steuerungseinheit (40) über eine zweite Wirkverbindung (41w) ansteuerbar sind und mittels der von der Steuerungseinheit (40) übermittelten Steuerungssignale die Wafer (22, 26) in einer vordefinierten relativen Position zueinander ausrichten.

5. Vorrichtung nach Anspruch 4, wobei das Verschiebemittel (41) die zweite Einrichtung (41) ist.

6. Vorrichtung nach Anspruch 2, wobei die Erfassungseinrichtung (42) mittels sichtbarem und/oder infrarotem Licht die relative Position der Wafer zueinander (22, 26) durch an den Wafern (22, 26) angebrachte oder integrierte Justiermarken (23, 27) ermittelt.

7. Vorrichtung nach Anspruch 1, wobei zwei Justiermarken an jedem Wafer (22, 26) angebracht oder integriert sind, wobei die Justiermarken (23, 27) vorzugsweise voneinander beabstandet angeordnet sind.

8. Vorrichtung nach Anspruch 7, wobei die Justiermarken (23, 27) Skalenstriche sind, die auf den Wafern (22, 26) aufgebracht sind.

9. Vorrichtung nach Anspruch 1, wobei der zweite Wafer (26) aus Glas besteht und der erste Wafer (22) aus Silizium besteht.

10. Verfahren zum Verbinden von zwei Wafern an zwei korrespondierenden Oberflächen der Wafer mit folgenden Schritten:
a. Aufbringen von Verbindungsmitteln auf zumindest eine der beiden korrespondierenden Oberflächen,
b. Kontaktierung der Wafer an den korrespondierenden Oberflächen,
c. Erfassung und Ausrichtung der Wafer durch Verschiebemittel entlang den durch eine vollflächige oder musterartige Verklebung in Kontakt stehenden korrespondierenden Oberflächen der Wafer, indem Ausrichtungsmittel in Übereinstimmung gebracht werden.
d. Verbindung der Wafer.

11. Verfahren nach Anspruch 10, bei dem die Wafer optisch ausgerichtet werden.

12. Verfahren nach Anspruch 10, bei dem die Ausrichtungsmittel zumindest teilweise in die Wafer integriert sind.

13. Verfahren nach Anspruch 10, bei dem die Wafer durch zumindest eine in jedem Wafer integrierte Justiermarke der Ausrichtungsmittel ausgerichtet werden.

14. Verfahren nach Anspruch 10, bei dem, vorzugsweise optische, Erfassungsmittel der Ausrichtungsmittel zur Erfassung der Ausrichtung verwendet werden.

15. Verfahren nach Anspruch 10, bei dem die Wafer bei der Kontaktierung in Schritt b an Hand der Waferkanten ausgerichtet werden.

## Claims

1. Device for connecting wafers (22, 26) to corresponding surfaces (22o, 26o) of wafers (22, 26) with the following features:
a. A unit (43) for applying a layer of connecting means (44) to at least one of the surfaces (22o, 26o) of wafers (22, 26),
b. A first system (20) for receiving and aligning a first wafer (22),
c. A second system (41) for receiving and aligning a second wafer (26) relative to the first wafer (22) and for contacting the corresponding surfaces (22o, 26o) of wafers (22, 26),
d. A control unit (40),
**characterized in that**
the device comprises aligning means for aligning wafers (22, 26) along the corresponding surfaces (22o, 26o) of wafers (22, 26) that are in contact by full-surface or pattern-like adhering, and the aligning means comprises a detecting system (42) for detecting the relative position of the two wafers (22, 26) that are to be aligned in contact with one another.

2. Device according to claim 1, whereby by means of a first active connection (42w) between the control unit (40) and the detecting system (42), the detecting system (42) sends signals to the control unit (40) on the relative position of wafers (22, 26) to one another.

3. Device according to claim 1, whose detecting system (42) is designed to be non-contact, in particular optical.

4. Device according to claim 1, whose alignment means comprise shifting means (41) that can be controlled by the control unit (40) via a second active connection (41w) and by means of which control signals sent from the control unit (40) align wafers (22, 26) in a predefined, relative position to one another.

5. Device according to claim 4, whereby the shifting means (41) is the second system (41).

6. Device according to claim 2, whereby by means of visible and/or infrared light, the detecting system (42) determines the relative positions of wafers (22, 26) to one another by alignment marks (23, 27) that are added to or integrated in wafers (22, 26).

7. Device according to claim 1, whereby two alignment marks are added to or integrated in each wafer (22, 26), whereby the alignment marks (23, 27) are preferably arranged spaced some distance apart.

8. Device according to claim 7, whereby the alignment marks (23, 27) are tick marks that are applied to wafers (22, 26).

9. Device according to claim 1, whereby the second wafer (26) consists of glass and the first wafer (22) consists of silicon.

10. Process for connecting two wafers to two corresponding surfaces of the wafers with the following steps:
a. Applying connecting means to at least one of the two corresponding surfaces,
b. Bonding the wafer to the corresponding surfaces,
c. Detecting and aligning the wafers by shifting means along the corresponding surfaces of the wafers that are in contact by full-surface or pattern-like adhering, by aligning means being coordinated,
d. Bonding of the wafers.

11. Process according to claim 10, in which the wafers are oriented optically.

12. Process according to claim 10, in which the aligning means are integrated at least partially in the wafers.

13. Process according to claim 10, in which the wafers are aligned by at least one alignment mark of the aligning means that is integrated in each wafer.

14. Process according to claim 10, in which preferably optical detecting means of the aligning means are used to detect the alignment.

15. Process according to claim 10, in which the wafers are aligned based on the wafer edges in the bonding in step b.

## Revendications

1. Dispositif de liaison de tranches (22,26) sur des surfaces correspondantes (220,260) de la tranche (22,26) comportant les caractéristiques suivantes :
a. une unité (43) pour appliquer une couche de moyen de liaison (44) sur au moins une des surfaces (220,260) de la tranche (22,26),
b. un premier dispositif (20) pour recevoir et aligner une première tranche (22),
c. un deuxième dispositif (41) pour recevoir et aligner une deuxième tranche (26) par rapport à la première tranche (22) et pour contacter les surfaces correspondantes (220,260) de la tranche (22,26),
d. une unité de commande (40),
**caractérisé en ce que**
le dispositif comprend des moyens d'alignement pour aligner la tranche (22,26) le long des surfaces correspondantes (220,260) de la tranche (22,26) étant en contact par l'intermédiaire d'un collage sur la totalité de la surface ou de type motif et les moyens d'alignement comprennent un dispositif de détection (42) pour détecter la position relative des deux tranches (22,26) à aligner étant en contact.

2. Dispositif selon la revendication 1, dans lequel le dispositif de détection (42) transmet au moyen d'une première liaison opérationnelle (42w) entre l'unité de commande (40) et le dispositif de détection (42) des signaux se rapportant à la position relative des tranches (22,26) l_{'}une par rapport à l'autre à l'unité de commande (40).

3. Dispositif selon la revendication 1, dont le dispositif de détection (42) est réalisé sans contact, notamment optique.

4. Dispositif selon la revendication 1, dont les moyens d'alignement comprennent des moyens de déplacement (41), qui peuvent être commandés par l'unité de commande (40) par l'intermédiaire d'une deuxième liaison opérationnelle (41w) et alignent les tranches (22,26) dans une position relative prédéfinie l'une par rapport à l'autre au moyen des signaux de commande transmis par l'unité de commande (40).

5. Dispositif selon la revendication 4, dans lequel les moyens de déplacement (41) sont le deuxième dispositif (41).

6. Dispositif selon la revendication 2, dans lequel le dispositif de détection (42) détermine au moyen d'une lumière infrarouge et/ou visible la position relative des tranches (22,26) l'une par rapport à l'autre par l'intermédiaire de marques d'ajustage (23,27) appliquées ou intégrées aux tranches (22,26).

7. Dispositif selon la revendication 1, dans lequel deux marques d'ajustage sont appliquées ou intégrées à chaque tranche (22,26), dans lequel les marques d'ajustage (23,27) sont disposées de préférence avec un espacement l'une par rapport à l'autre.

8. Dispositif selon la revendication 7, dans lequel les marques d'ajustage (23,27) sont des traits de graduation, qui sont appliquées sur les tranches (22,26).

9. Dispositif selon la revendication 1, dans lequel la deuxième tranche (26) est constituée de verre et la première tranche (22) est constituée de silicium.

10. Procédé de liaison de deux tranches sur deux surfaces correspondantes de la tranche avec les étapes suivantes consistant à:
a. appliquer des moyens de liaison sur au moins une des deux surfaces correspondantes,
b. contacter la tranche sur les surfaces correspondantes,
c. détecter et aligner la tranche par l'intermédiaire de moyens de déplacement le long des surfaces de tranche correspondantes étant en contact par l'intermédiaire d'un collage sur la totalité de la surface ou du type motif, en faisant coïncider les moyens d'alignement,
d. lier les tranches.

11. Procédé selon la revendication 10, dans lequel les tranches sont alignées optiquement.

12. Procédé selon la revendication 10, dans lequel les moyens d'alignement sont intégrés au moins partiellement dans la tranche.

13. Procédé selon la revendication 10, dans lequel les tranches sont alignées par au moins une des marques d'ajustage intégrées à chaque tranche des moyens d'alignement.

14. Procédé selon la revendication 10, dans lequel des moyens de détection, de préférence optique, des moyens d'alignement sont utilisés pour détecter l'alignement.

15. Procédé selon la revendication 10, dans lequel les tranches sont orientées lors du contact à l'étape b en se basant sur les arêtes de tranches.
